# EUROPÄISCHE PATENTANMELDUNG

(11) **EP 0 555 648 A2**
(43) Veröffentlichungstag der Anmeldung: **18.08.1993**
(21) Anmeldenummer: 93100469.1
(22) Anmeldetag: 14.01.1993
(51) Int. Cl.: H03K 17/687, H03K 17/04

(54) **Schaltungsanordnung zum Ansteuern von feldgesteuerten Leistungsschaltern**

(30) Priorität: 16.01.1992 DE 4201014; 28.01.1992 DE 4202251
(71) Anmelder: HEINRICH KOPP AG, D-63796 Kahl am Main (DE)
(72) Erfinder: HEINRICH KOPP AG, D-63796 Kahl am Main (DE)
(74) Vertreter: Rüger, Rudolf, Dr.-Ing.

(57) **Zusammenfassung**

Ausgehend von der Aufgabe, eine Schaltungsanordnung (1) mit einem Leistungsfeldeffekttransistor (2) zu schaffen, die sehr verlustarm arbeitet und mit geringem Bauvolumen realisierbar ist, weist die Schaltungsanordnung zwei nach Art einer Darlington-Schaltung miteinander verbundene Transistoren (2, 4) auf. Des weiteren ist eine Steuerschaltung (3) für die Transistoren (2, 4) vorgesehen, die einen Ansteuereingang (21) aufweist und die den Eingangstransistor (4) lediglich für den Übergang des Ausgangstransistors (2) von dem Aus-Zustand in dessen Ein-Zustand leitend steuert und ansonsten gesperrt hält.

Die Steuerschaltung (3) benötigt keine eigene Versorgungsspannung, so daß hier jegliche zusätzliche Stromversorgung entfällt.

## Beschreibung

Um größere Ströme und Spannungen zu schalten, werden zunehmend feldgesteuerte Bauelemente, also spezielle Feldeffekttransistoren verwendet. Obwohl diese Bauelemente im statischen Zustand, d.h. im ein- oder im ausgeschalteten Zustand keine Steuerleistung aufnehmen, müssen sie doch niederohmig angesteuert werden. Die Gate-Elektroden, die mit einem Ohm'schen Widerstand in der Größenordnung von 10⁸ bis 10¹³ Ohm gegen das übrige Substrat isoliert sind, weisen gerade bei Leistungsfeldeffekttransistoren eine erhebliche Eingangskapazität auf. Zur Umladung dieser Kapazität fließt während des Umschaltvorganges ein gewisser Gate-Strom, der kurzzeitig sehr hohe Werte annehmen kann. Dieser Strom läßt sich auch nicht verringern, da er von der konstruktiv bedingten Gate-Source- und Gate-Drain-Kapazität abhängig ist. Um diesen Strom liefern zu können, muß die Ansteuerschaltung einen geringen Innenwiderstand aufweisen.

Während Leistungsfeldeffekttransistoren ausgangsseitig Spannungen schalten, die in dem Bereiche von einigen 100 Volt liegen können, sind zur Umschaltung von dem leitenden in den gesperrten Zustand und umgekehrt nur relativ geringe Spannungshübe von wenigen Volt an der Gate-Elektrode des Feldeffekttransistors erforderlich.

Bei bekannten Ansteuerschaltungen wird die Gate-Spannung des Leistungsfeldeffekttransistors aus einer niederohmig verfügbaren stabilisierten Kleinspannung abgeleitet.

Wegen der aufzubringenden relativ hohen Umladeströme an dem Gate des Leistungsfeldeffekttransistors ist eine entsprechend belastbare Spannungsquelle zur Versorgung der Ansteuerschaltung notwendig, was wegen des erforderlichen Netztransformators ein großes Bauvolumen zur Folge hat.

Desweiteren sind Schaltungen bekannt geworden, bei dem die Gate-Spannung über einen Widerstand und eine Z-Diode aus der Versorgungsspannung des Leistungsfeldeffekttransistors abgeleitet wird. Dabei entsteht insbesondere bei hohen Versorgungsspannungen an dem Widerstand eine beträchtliche Verlustleistung. Schwankt die Versorgungsspannung, muß der Widerstand für deren geringsten Wert relativ niederohmig ausgelegt werden. Hat die Versorgungsspannung gerade ihren höchsten Wert, ist die Verlustleistung besonders groß. Außerdem fällt die Verlustleistung immer an, also unabhängig davon, ob der Leistungsfeldeffekttransistor in einem statischen Zustand ist, oder ob er gerade umgeschaltet wird.

Davon ausgehend ist es die Aufgabe der Erfindung, eine Schaltungsanordnung mit einem Leistungsfeldeffekttransistor zu schaffen, die sehr verlustarm arbeitet und mit geringem Bauvolumen realisierbar ist.

Die Aufgabe wird durch eine Schaltungsanordnung gemäß dem Anspruch 1 gelöst.

Durch die Zusammenschaltung eines selbstsperrenden Leistungsfeldeffekttransistors mit einem Eingangstransistor nach Art einer Darlington-Schaltung wird der zur Umladung der Gate-Kapazität des Leistungsfeldeffekttransistors benötigte Strom auf einfache Weise aus der Versorgungsspannung des Lastkreises abgeleitet. Der Eingangstransistor versorgt dabei das Gate des Ausgangstransistors mit dem benötigten Strom. Dadurch, daß die Steuerschaltung den Eingangstransistor nur genau solange aufsteuert, bis die Gate-Kapazität des Ausgangstransistors aufgeladen ist, fließt auch nur während dieses Umladeprozesses ein Strom, so daß auch nur in dieser Zeit Verlustleistung entstehen kann. Ist das Gate des Ausgangstransistors einmal auf einer Spannung angelangt, die ausreicht, den Ausgangstransistor leitend zu halten, schaltet die Steuerschaltung den Eingangstransistor ab, womit praktisch keine Verlustleistung mehr entsteht. Im zeitlichen Mittel ist die umgesetzte Verlustleistung so gering, daß der Eingangstransistor ohne Kühlkörper auskommt. Die Schaltung wird dadurch auch sehr klein. Die Steuerschaltung benötigt keine eigene Versorgungsspannung, so daß hier jegliche zusätzliche Stromversorgung entfällt. Ein Netztrafo oder andere Bauelemente mit großem Volumen sind nicht erforderlich.

Besonders einfach fällt die Steuerschaltung aus, wenn als Eingangstransistor ein selbstleitender Mosfet Verwendung findet. Dieser leitet bereits, wenn seine Source-Elektrode und sein Gate das gleiche Potential aufweisen. Mittel zur Erzeugung einer höheren Spannung als die an seiner Source-Elektrode sind zum Einschalten dieses Transistortyps nicht erforderlich.

Eine vorteilhafte Schaltung ergibt sich, wenn der Eingangstransistor und der Ausgangstransistor von gleichem Leitfähigkeitstyp sind. Dabei führt die Verwendung von n-Kanal-Transistoren zum einen zu sehr kurzen Schaltzeiten und zum anderen ist es auf besonders einfache Weise möglich, einen in einem Lastkreis liegenden Verbraucher von einer positiven Versorgungsspannung gegen eine negative Spannung zu schalten. Außerdem ertragen diese Transistoren große Sperrspannungen.

Wenn die Steuerschaltung zwischen die Gate-Elektrode des Ausgangstransistors und die Source-Elektrode des Eingangstransistors geschaltet ist, kann die Steuerschaltung den Strom, den der Eingangstransistor auf die Gate-Elektrode des Ausgangstransistors liefert, zu ihrer eigenen Steuerung heranziehen. Dadurch läßt sich die Steuerschaltung besonders einfach auslegen.

Wird die Steuerschaltung mit der Source-Elektrode des Ausgangstransistors verbunden, haben beide ein gemeinsames Bezugspotential, wodurch besonders der Sperrvorgang des Ausgangstransistors erleichtert wird.

Wenn die Steuerschaltung einen Verbindungszweig enthält, über den die Source-Elektrode des Eingangstransistors mit der Gate-Elektrode des Ausgangstransistors verbunden ist, kann ausgehend von einer hohen Betriebsspannung ein besonders kurzer und kräftiger Stromimpuls auf die Gate-Elektrode des Ausgangstransistors geleitet werden, so daß dieser in äußerst kurzer Zeit leitend wird und die Verlustleistung während des Umschaltprozesses auch in dem Ausgangstransistor begrenzt bleibt.

Wenn der Verbindungszweig ein spannungsbegrenzendes Bauelement, vorzugsweise eine Z-Diode enthält, deren Anode mit der Gate-Elektrode des Ausgangstransistors verbunden ist und deren Z-Spannung größer ist als der Betrag der Schwellenspannung des Einganstransistors, kann der Eingangstransistor auf einfachste Weise gesperrt werden. Die Anordnung einer Z-Diode in diesem Verbindungszweig hat den wesentlichen Vorteil, daß sie für geringe den Eingangstransistor durchfließende Leckströme hochohmig ist, während sie für den kurzen kräftigen Stromstoß, mit dem das Gate des Ausgangstransistors beaufschlagt wird, im Z-Durchbruch sehr niederohmig ist. Dadurch wird der Ausgangstransistor sehr schnell in den leitenden Zustand gesteuert, wodurch die Umschaltverluste gering bleiben. Die Z-Diode schafft eine konstante Spannungsdifferenz zwischen dem Gate des Ausgangstransistors und der vergleichsweise bei einer höheren positiven Spannung liegenden Source-Elektrode des Eingangstransistors, wobei die Spannungsdifferenz die Schwellenspannung des Eingangstransistors überschreitet. Auf diese Weise bleibt der Eingangstransistor während der Sperrphase des Ausgangstransistors geschlossen, nämlich wenn die Gatespannungen an beiden Transistoren auf Null geschaltet sind.

Vorteilhafterweise enthält die Steuerschaltung einen Verbindungszweig, über den die Source-Elektrode des Eingangs- oder Treibertransistors mit der Gate-Elektrode verbunden ist. Dadurch wird erreicht, daß der Eingangstransistor, der vom selbstleitenden Typ ist, sich ohne großen Schaltungsaufwand selbst in den leitenden Zustand steuern kann. Da die Spannungsdifferenz zwischen der Source- und der Gate-Elektrode des Eingangstransistors klein ist, ist die in dem Widerstand umgesetzte Verlustleistung gering.

Wenn der Verbindungszweig ein strombegrenzendes Bauelement, bspw. einen Ohm'schen Widerstand enthält, läßt sich der Eingangstransistor an seiner Gate-Elektrode weiterhin abschalten, ohne daß der Verbindungszweig zwischen seiner Source-Elektrode und seiner Gate-Elektrode unterbrochen werden müßte. Dadurch wird die Steuerschaltung besonders einfach.

Wenn die Steuerschaltung einen Schaltungsknoten aufweist, der im Aus-Zustand des Ausgangstransistors das Potential der Source-Elektrode des Ausgangstransistors und im Ein-Zustand ein demgegenüber positives Potential aufweist, ist ein Punkt vorhanden, mit dem sich der Eingangstransistor auf besonders einfache Weise steuern läßt. Durch den Spannungsvergleich zwischen der Gate-Elektrode des Ausgangstransistors und diesem Schaltungsknoten stellt der Eingangstransistor jederzeit den Ladezustand der Eingangskapazität des Ausgangstransistors fest und regelt den Ladestrom entsprechend ein.

Wenn der Schaltungsknoten über ein spannungsbegrenzendes Bauelement, vorzugsweise eine Z-Diode, mit der Source-Elektrode des Ausgangstransistors verbunden ist, wobei die Z-Spannung gleich der vorzeichenbehafteten Summe aus der gewünschten Gatespannung an dem Ausgangstransistor, der Z-Spannung der anderen Z-Diode und der Schwellenspannung des Eingangstransistors ist, ist auf einfache Weise gewährleistet, daß die Gate-Spannung an dem Ausgangstransistor keine unzulässigen Werte annehmen kann.

Wenn die Gate-Elektrode des Ausgangstransistors im Aus-Zustand der Schaltung niederohmig mit der Source-Elektrode des Ausgangstransistors verbunden ist, ist der Ausgangstransistor sicher gesperrt. Eine besonders einfache Lösung ergibt sich dafür, wenn die Gate-Elektrode des Ausgangstransistors über eine in Flußrichtung gepolte Diode mit dem Schaltungsknoten verbunden ist, der über einen zu der Z-Diode parallel geschalteten Transistor elektrisch mit seiner eigenen Source-Elektrode verbindbar ist.

Im übrigen sind Weiterbildungen Gegenstand von Unteransprüchen.

In der Zeichnung sind Ausführungsbeispiele der Erfindung dargestellt. Es zeigen:
- Fig. 1: die erfindungsgemäße Schaltungsanordnung als Blockschaltbild,
- Fig. 2: charakteristische Strom- und Spannungsverläufe an ausgewählten Punkten der Schaltungsanordnung,
- Fig. 3: ein Ausführungsbeispiel der Schaltungsanordnung mit einer im Schaltbild dargestellten Steuerschaltung,
- Fig. 4: ein anderes Ausführungsbeispiel der Schaltungsanordnung mit einer Ansteuerschaltung, die besonders steile Schaltflanken produziert,
- Fig. 5: ein weiteres Ausführungsbeispiel der Schaltungsanordnung mit einer Ansteuerschaltung mit entkoppelter Ansteuerung des Eingangs- und des Ausgangstransistors und
- Fig. 6: ein Ausführungsbeispiel der Schaltungsanordnung mit einer vereinfachten Steuerschaltung.

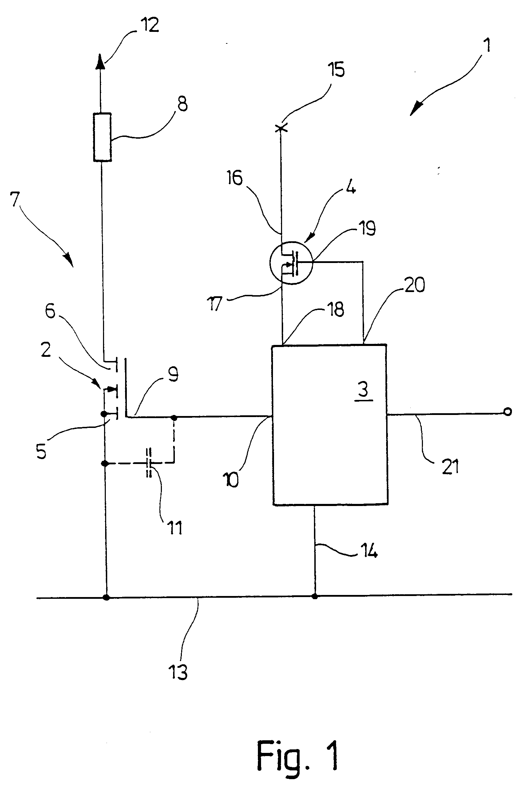

In Fig. 1 ist eine Schaltungsanordnung 1 zum verlustarmen Ansteuern eines Leistungsfeldeffekttransistors 2 dargestellt, der im Schalterbetrieb arbeitet. Die Schaltungsanordnung 1 weist den Leistungsfeldeffekttransistor 2 als Ausgangstransistor, eine Steuerschaltung 3 sowie einen Treiber- oder Eingangstransistor 4 auf, der im wesentlichen als Sourcefolger arbeitet.

Der Ausgangstransistor 2 ist ein selbstsperrender n-Kanal-Mosfet, dessen Source-Elektrode 5 und Drain-Elektrode 6 in einem Lastkreis 7 in Serie mit einer zu schaltenden Last 8 liegen. Mit seiner Gate-Elektrode 9 ist der Ausgangstransistor 2 mit einem Ausgang 10 der Steuerschaltung 3 verbunden. Die Gate-Elektrode 9 des Ausgangstransistors 2 weist eine beträchtliche Eingangskapazität auf. In der Fig. 1 ist die Eingangskapazität gestrichelt eingetragen und mit 11 bezeichnet. Die Drain-Elektrode 6 ist über die Last 8 an eine Versorgungsspannung 12 geschaltet. Die Source-Elektrode 5 des Ausgangstransistors 2 und der Anschluß 14 der Steuerschaltung 3 sind an ein Bezugspotential 13 (Masse) gelegt. Anstelle des Mosfet kann auch ein IGBT oder eine Zusammenschaltung aus einem Mosfet und einem Bipolartransistor verwendet werden, soweit diese Schaltung ähnliche Eingangsparameter bzw. ähnliches Eingangsverhalten wie ein selbstsperrender Mosfet aufweist.

Die Steuerschaltung 3 ist über die gesteuerte Strecke des Eingangstransistors 4 mit einer Versorgungsspannung 15 verbunden. Die gesteuerte Strecke liegt zwischen einer Drain-Elektrode 16 und einer Source-Elektrode 17 des Eingangstransistors 4. Die Source-Elektrode 17 ist mit einem Anschluß 18 der Steuerschaltung 3 verbunden. Zur Steuerung der Leitfähigkeit der gesteuerten Strecke weist der Eingangstransistor 4 eine Steuerelektrode 19 (Gate-Elektrode) auf, die mit einem Anschluß 20 der Steuerschaltung 3 verbunden ist. Zum Ansteuern derselben weist die Steuerschaltung 3 einen Ansteuereingang 21 auf, so daß sie abhängig von einem an dem Ansteuereingang 21 anliegenden elektrischen Signal den Ausgangstransistor 2 in den Ein-Zustand oder in den Aus-Zustand schaltet.

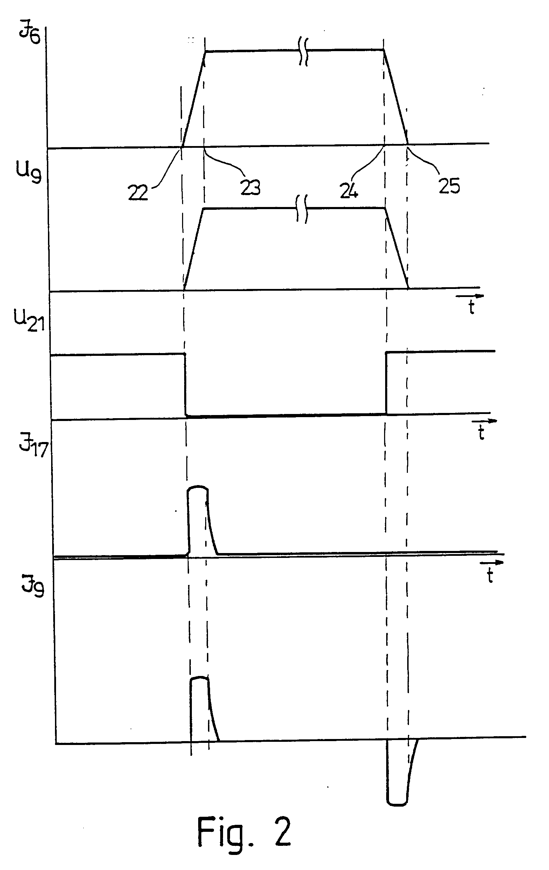

Die insoweit beschriebene Schaltung funktioniert wie folgt:
Zur Erläuterung der Arbeitsweise der in Fig. 1 dargestellten Schaltung wird zusätzlich auf die Fig. 2 Bezug genommen. In der Fig. 2 sind charakteristische Strom- und Spannungsverläufe der Schaltungsanordnung 1 dargestellt, wobei zur Erleichterung der Lesbarkeit die dargestellten Ströme und Spannungen mit einem Index versehen sind, der mit dem Bezugszeichen des Bauelementes übereinstimmt, an dem der betreffende Strom oder die Spannung auftritt. Um die Darstellung insbesondere in den Übergängen der Schaltungsanordnung und des Ausgangstransistors 2 von dem Ein- in den Aus-Zustand zu verbessern, ist der Zeitmaßstab nichtlinear gedehnt.

Zu einem beliebigen Anfangszeitpunkt liegt an dem Ansteuereingang 21 eine von Null verschiedene Steuerspannung U₂₁ an, und der Ausgangstransistor 2 ist zunächst gesperrt. Damit ist der Lastkreis 7 stromfrei, es fließt kein Drainstrom I₆, und an der Drain-Elektrode 6 liegt gegenüber der Source-Elektrode 5 und dem Bezugspotential 13 die Versorgungsspannung 12 an, die bspw. einige 100 Volt betragen kann. Die Gate-Elektrode 9 wird von der Steuerschaltung 3 auf einer Gatespannung U₉ gehalten, die etwa dem Bezugspotential 13 entpricht. Demzufolge ist die Eingangskapazität 11 entladen.

Desweiteren liegen an dem Anschluß 20 der Steuerschaltung 3 das Bezugspotential 13 und an dem Anschluß 17 eine positive Spannung an, so daß der Eingangstransistor 4 eine negative Gatevorspannung hat und fast völlig gesperrt ist. Es fließt lediglich ein verschwindend geringer Drainstrom I₁₇. Dieser Zustand der Schaltungsanordnung 1 wird solange aufrecht erhalten, wie die an dem Eingang 21 anliegende Steuerspannung U₂₁ einen bestimmten, von Null verschiedenen Wert behält.

Wird nun, um den Ausgangstransistor 2 zu einem Zeitpunkt 22 einzuschalten, die Steuerpannung U₂₁ sprungartig auf Null geschaltet, steuert die Steuerschaltung 3 über den Anschluß 20 die gesteuerte Strecke des Eingangstransistors 4 auf. Aus der Spannungsquelle 15 fließt ein kräftiger Drainstrom I₁₇ in die Steuerschaltung 3 und wird von dieser zur Umladung der Eingangskapazität 11 des Ausgangstransistors 2 auf die Gate-Elektrode 9 des Ausgangstransistors 2 geleitet. Der Gatestrom I₉ hat kurzzeitig einen sehr großen Betrag, so daß sich die Gate-Source-Kapazität 11 relativ schnell auflädt, wodurch die Gate-Elektrode 9 gegenüber der Source-Elektrode 5 positiv wird. Wie sich aus dem Obigen ergibt, wird bei diesem Funktionsintervall davon Gebrauch gemacht, daß der Source-Strom des Eingangstransistors 4 im wesentlichen gleich dem Gate-Strom des Ausgangstransistors 2 ist. Damit verhält sich die Schaltung während dieses Zeitintervalls, bis die Gate-Source-Kapazität aufgeladen ist, wie eine Darlington-Schaltung, bei der der Steuerstrom des zweiten Transistors gleich dem Emitter- oder Source-Strom des ersten Transistors ist. Die Schaltungsanordnung aus dem Eingangstransistor 4 und dem Ausgangstransistor 2 ist somit ähnlich einer Darlington-Schaltung.

Sobald die Spannung an der Gate-Elektrode 9 die Schwellenspannung des Ausgangstransistors 2 überschritten hat, beginnt in dem Lastkreis 7 der Drainstrom I₆ zu fließen. Entsprechend verringert sich die zwischen der Drain-Elektrode 6 und der Source-Elektrode 5 anstehende Spannung so daß sich eine steile Schaltflanke ausgehend von der hohen positiven Versorgungsspannung 12 auf das niedrige Bezugspotential 13 ergibt.

Die Steuerschaltung 3 verbindet über den niederohmig geschalteten Eingangstransistor 4 die Versorgungsspannung 15 kurzzeitig mit der Gate-Elektrode 9 des Ausgangstransistors 2. Die Folge ist der in der Fig. 2 dargestellte kurze, jedoch starke Stromimpuls durch den Eingangstransistor 4. Während dessen geht die Spannung an der Drain-Elektrode 6 kontinuierlich gegen Null. Sobald der Ausgangstransistor 2 durchgeschaltet ist (Zeitpunkt 23), und die Spannung zwischen der Drain-Elektrode 6 und der Source-Elektrode 5 auf eine minimale Restspannung abgefallen ist, sperrt die Steuerschaltung den Eingangstransistor 4 fast völlig, d.h. bis auf einen Ruhestrom, der etwa um den Faktor 100 oder mehr kleiner ist als der Strom bei dem Laden der Eingangskapazität 11.

Die Spannung U_{9 an der Gate-Elektrode 9} liegt im Bereich von 10 - 15 Volt. Bei positiver Gate-Elektrode 9 ist kein weiterer Strom erforderlich, um den im Ein-Zustand befindlichen Ausgangstransistor 2 eingeschaltet zu halten. Die Steuerschaltung 3 schaltet deshalb nun die gesteuerte Strecke des Eingangstransistors 4 hochohmig, so daß sowohl in der Steuerschaltung 3, als auch in dem Eingangstransistor 4 die Verlustleistung reduziert werden und extrem geringe Werte annehmen.

Da der Eingangstransistor 4 im wesentlichen als Schalter wirkt, der nur in der Übergangszeit der Einschaltphase eingeschaltet ist und ansonsten abgeschaltet bleibt, braucht die Versorgungsspannung 15 nicht stabilisiert zu werden. Sie kann sowohl sehr hoch als auch relativ niedrig sein. Der Arbeitsbereich geht von einigen 100 Volt als Obergrenze bis zu einer Untergrenze von wenig mehr als 10 - 15 Volt. Da die Versorgungsspannung in weiten Grenzen schwanken darf, kann sie bei Bedarf sogar direkt dem Lastkreis 7 entnommen werden.

Zum Abschalten des Ausgangstransistors 2 zu einem willkürlichen Zeitpunkt, der in Fig. 2 bei 24 angedeutet ist, wird die Steuerspannung U₂₁ auf einen positiven Wert geschaltet. In dem mittleren Diagramm für U₂₁ in der Fig. 2 ist das durch eine Rechteckflanke veranschaulicht. Die Steuerschaltung 3 legt nun den Ausgang 10 und damit die Gate-Elektrode 9 des Ausgangstransistors 2 niederohmig auf das Bezugspotential 13, also auf Masse. Der Entladestrom der Eingangskapazität 11 fließt über die Anschlüsse 10 und 14 der Steuerschaltung 3 gegen Masse ab. Der Entladestrom ist als Gatestom I₉ in der Fig. 2 dargestellt. Der Eingangstransistor 4 bleibt während dieses Vorganges durchgehend gesperrt, so daß kein nennenswerter Strom I₁₇ fließt und auch keine Verlustleistung an dem Eingangstransistor auftritt.

Während die an der Gate-Elektrode 9 anstehende Spannung abnimmt wird der Ausgangstransistor 2 hochohmig, wodurch sich der in den Lastkreis 7 fließende Drainstrom I₆ verringert und die Spannung zwischen der Drain-Elektrode 6 und der Source-Elektrode 5 zunimmt. Wenn der Ausgangstransistor 2 völlig gesperrt ist, ist der Lastkreis 7 zu dem Zeitpunkt 25 stromlos. Da bei dem Abschaltvorgang lediglich die relativ geringe Gatespannung U₉ von etwa 10 - 15 Volt kurzzuschließen war, ist die Verlustleistung, die dabei in der Steuerschaltung umgesetzt wird, sehr gering.

In Fig. 1 ist der Eingangstransistor 4 als Einzeltransistor vom selbstleitenden Typ veranschaulicht. Anstelle dieses Einzeltransistors kann auch eine integrierte Schaltung mit gleichem oder vergleichbarem Schaltungsverhalten verwendet werden.

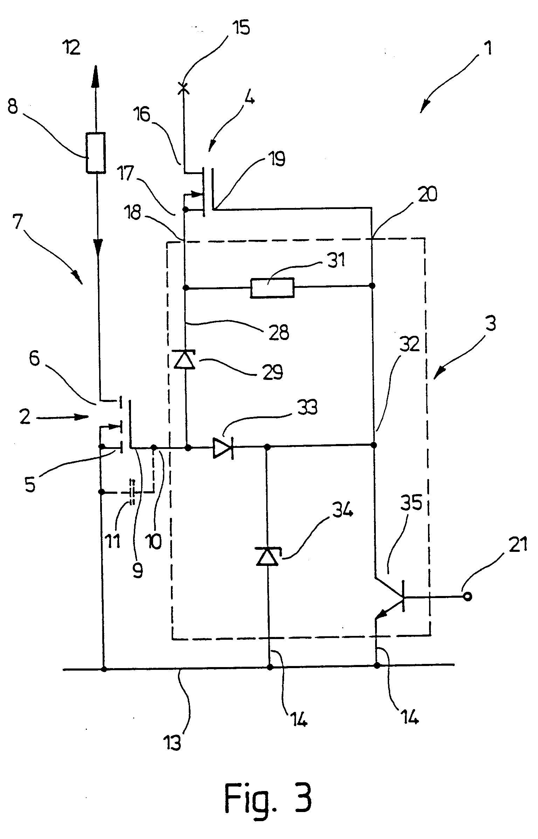

Ein Ausführungsbeispiel der in der Funktion vorstehend beschriebenen Schaltungsanordnung ist in Fig. 3 dargestellt. Schaltungsteile und Bauelemente, die in der vorstehenden Beschreibung bereits mit Bezugszeichen versehen worden sind, tragen in der Fig. 3 die gleichen Bezugszeichen wie in der Fig. 1.

Die Steuerschaltung 3 weist einen Verbindungszweig 28 auf, der die Source-Elektrode 17 des Eingangstransistors 4 mit dem Anschluß 10 und damit mit der Gate-Elektrode 9 des Ausgangstransistors 2 verbindet. In diesen Verbindungszweig 28 liegt eine Z-Diode 29 und zwar so, daß ihre Anode mit dem Anschluß 10 und ihre Kathode mit der Source-Elektrode 17 des Eingangstransistors 4 verbunden sind. Von der Kathode der Z-Diode 29 führt ein relativ hochohmiger Widerstand 31 an einen Schaltungsknoten 32, an den auch die Gate-Elektrode 19 angeschlossen ist. Zwischen dem Schaltungsknoten 32 und der Anode der Z-Diode 29 liegt eine Diode 33, die so gepolt ist, daß ihre Kathode an dem Schaltungsknoten 32 liegt. Desweiteren ist der Schaltungsknoten 32 über eine spannungsbegrenzende Z-Diode 34, der ein npn-Transistor 35 mit seiner Kollektor-Emitter-Strecke parallel geschaltet ist, auf das Bezugspotential (die Masse) 13 geklemmt. Die Basis des Transistors 35 ist aus der Steuerschaltung 3 herausgeführt und bildet deren Ansteuereingang 21. Im Falle der Ansteuerung mit Licht wird der Transistor 35 durch eine Photodiode oder einen Phototransistor ersetzt.

Die Funktionsweise der oben beschriebenen Schaltungsanordnung nach Fig. 3 ist wie folgt:

Die Schaltungsanordnung 1 weist zwei statische Zustände auf; sie kann entweder in dem Ein-Zustand oder in dem Aus-Zustand sein. Dementsprechend ist der Ausgangstransistor 2 entweder voll offen oder ganz gesperrt, wodurch in Übereinstimmung mit der Funktionsbeschreibung der Schaltung nach Fig. 1, der in dem Lastkreis 7 fließende Drainstrom gesteuert wird. Die Zustände der Schaltungsanordnung 1 werden von einer an den Ansteuereingang 21 als Steuersignal angelegten Steuerspannung U₂₁ gesteuert.

Es sei angenommen, daß die an dem Ansteuereingang 21 anliegende Steuerspannung positiv ist. In die Basis des Transistors 35 fließt ein Basisstrom, so daß der Transistor 35 leitend geschaltet ist. Der Schaltungsknoten 32 liegt somit auf einem Potential, das höchstens wenige 100 mV oberhalb des Bezugspotentials 13 liegt. Folglich ist die Gate-Elektrode 9 des Ausgangs-Transistors 2 über die Diode 33 und den Transistor 35 praktisch auf das Bezugspotential 13 und damit auf sein eigenes Source-Potential geklemmt. Da der Ausgangstransistor 2, wie bereits zu Anfang dargelegt, ein selbstsperrender n-Kanal-Mosfet ist, sperrt dieser sicher.

Auch der Eingangstransistor 4 ist fast ganz gesperrt. Es fließt lediglich ein geringer Drainstrom I₁₇ von seiner Source-Elektrode 17 über den Widerstand 31, der mit der Gate-Elektrode 19 verbunden ist, gegen Masse ab. Die über den Widerstand 31 abfallende Spannung wirkt als negative Gate-Vorspannung für den Eingangstransistor 4 und hält diesen weitgehend gesperrt, da dieser Spannungsabfall die Schwellenspannung des Eingangstransistors 4 überschreitet. Die über den Widerstand 31 abfallende Spannung liegt unterhalb oder gerade bei der Z-Spannung der Z-Diode 29 zuzüglich der Durchlaßspannung der Diode 33. Diese sind demzufolge hochohmig und führen keinen Strom. In diesem Zustand sind die Steuerschaltung 3 und der Eingangstransistor 4 nahezu stromlos. In der Steuerschaltung 3 fließen im wesentlichen lediglich der in den Ansteuereingang 21 eingespeiste Steuerstrom als Basis-Emitter-Strom des Transistors 35 sowie der geringe Strom durch den Widerstand 31.

Zu dem in Fig. 2 mit dem Bezugszeichen 22 gekennzeichneten Zeitpunkt wird zum Umschalten der Schaltungsanordnung 1 in den Ein-Zustand der Ansteuereingang 21 auf Null geschaltet. In der Folge sperrt der Transistor 35 mit einer steilen Flanke. Der über den Widerstand 31 fließende Strom wird dadurch abgeschaltet, wodurch der Spannungabfall an dem Widerstand 31 und damit auch die negative Gatevorspannung an dem Eingangstransistor 4 verschwinden. Die geringe Eingangskapazität des Eingangstransistors 4 entlädt sich ohne weiteres über den Widerstand 31. Ohne negative Gatevorspannung ist der Eingangstransistor 4, der vom selbstleitenden Typ ist, praktisch schon ganz durchgesteuert.

Aus der Versorgungsspannung 15 fließt nun ein kräftiger Strom über die Drain-Source-Strecke des Eingangstransistors 4 und die Z-Diode 29 auf die Gate-Elektrode 9 des Ausgangstransistors 2 und steuert diesen in der vorbeschriebenen Weise in den leitenden Zustand. Die Z-Diode 29 befindet sich dabei im Z-Durchbruch und stellt eine konstante Potentialdifferenz zwischen der Source-Elektrode 17 des Eingangstransistors 4 und der Gate-Elektrode 9 des Ausgangstransistors 2 her. Der über die Z-Diode 29 auf die Gate-Elektrode 9 fließende Strom lädt die Eingangskapazität 11 in der vorbeschriebenen Weise auf, so daß das Potential an der Gate-Elektrode 9 über der Zeit schnell ansteigt.

An der Z-Diode 29 fällt eine Spannung ab, die ihrer Z-Spannung entspricht. Für diese abfallende Spannung ist die Diode 33 in Sperrichtung gepolt, so daß kein Strom durch den Widerstand 31 parallel zu der Z-Diode 29 abfließen kann. Es kann auch kein Strom durch den Widerstand 31 über die Z-Diode 34 abfließen, da deren Z-Spannung höher liegt als das Potential an der Source-Elektrode 17. Folglich fällt auch keine Spannung über dem Widerstand 31 ab, so daß der Eingangstransistor leitend bleibt.

Der über den Eingangstransistor 4 in die Gate-Elektrode 9 des Ausgangstransistors 2 fließende Strom bewirkt ein weiteres Aufladen der Eingangskapazität 11. Die Gatespannung U₉ steigt an, bis die Spannung an der Source-Elektrode 17 des Eingangstransistors 4 und damit auch die Spannung an dem Schaltungsknoten 32 die Durchbruchspannung der Z-Diode 34 erreichen. Diese wird leitend und klemmt das Potential des Schaltungsknotens 32 auf ihrer Z-Spannung fest. Über den Widerstand 31 fließt jetzt ein Strom von der Source-Elektrode 17 zu der Z-Diode 34. Die dadurch über dem Widerstand 31 abfallende Spannung wirkt als negative Gatevorspannung für den Eingangstransistor 4, so daß dieser sperrt, sobald der Spannungsabfall über dem Widerstand 31 die negative Schwellenspannung des Eingangstransistors 4 erreicht hat.

Der Ausgangstransistor 2 ist nun voll durchgesteuert und der Eingangstransistor 4 ist, nachdem er kurzzeitig voll durchgesteuert war, wieder bis auf den Ruhestrom gesperrt. An seiner Drain-Elektrode 17 steht eine Spannung an, die gleich der Summe aus der Z-Spannung der Z-Diode 34 und der Schwellenspannung des Eingangstransistors 4 ist und die von dem Eingangstransistor 4 innerhalb der Leitphase stabil auf dem genannten Wert gehalten wird. Es ist möglich, diese Spannung zur Spannungsversorgung anderer Schaltungsteile zu verwenden, wobei ein Strom von der Source-Elektrode 17 abgenommen werden kann. Dieser Strom addiert sich zu dem ohnehin fließenden Reststrom.

Zum Abschalten des Ausgangstransistors 2 zu einem willkürlichen Zeitpunkt 24 wird eine positive Steuerspannung U₂₁ an den Ansteuereingang 21 der Steuerschaltung 3 angelegt. Der Transistor 35 wird praktisch sofort leitend und entlädt über die Diode 33 die Eingangskapazität 11 des Ausgangstransistors 2, indem er die Gate-Elektrode 9 äußerst niederohmig gegen das Bezugspotential 13 und damit gegen die Source-Elektrode 5 schaltet. Die Spannungsänderung an der Gate-Elektrode 9 erfolgt so schnell, daß der in dem Lastkreis 7 fließende Strom praktisch sofort abgeschaltet wird, wodurch auch in dem Ausgangstransistor 2 nur sehr wenig Verlustleistung umgesetzt wird. Gleichzeitig kommutiert der Strom, der aus dem Widerstand 31 über die Z-Diode 34 fließt, auf den Transistor 35. So bleibt der Spannungsabfall an dem Widerstand 31 als negative Gatevorspannung erhalten, wodurch der Eingangstransistor 4 im wesentlichen gesperrt bleibt. Über ihn fließt während des Sperrvorganges kein erhöhter Drainstrom I₁₇, so daß auch keine nennenswerte Verlustleistung entstehen kann.

An der Source-Elektrode 17 des Eingangstransistors 4 liegt nun eine Spannung an, die etwa gleich seiner Schwellenspannung ist und von dem Eingangstransistor, während die Steuerschaltung 3 im Aus-Zustand ist, stabil auf dem Wert der Schwellenspannung gehalten wird. Wenn an der Source-Elektrode 17 eine Versorgungsspannung für eine anderweitige Schaltungsteile abgenommen wird, erhöht sich der durch den Eingangstransistor 4 fließende Reststrom um den Betrag des entnommenen Stromes.

Die Spannung an der Source-Elektrode 17 schwankt entsprechend der Steuerspannung U₂₁ zwischen dem Wert im Ein-Zustand und dem Wert im Aus-Zustand hin und her. Zur Stromversorgung anderweitiger Baugruppen kann ein Ladekondensator über eine Entkopplungsdiode an die Source-Elektrode 17 angeschlossen sein. Die Spannung an dem Ladekondensator ist dann im wesentlichen stabilisiert und entspricht der Spannung an der Source-Elektrode 17 im Ein-Zustand, nämlich der Summe aus der Schwellenspannung und der Z-Spannung der Z-Diode 34.

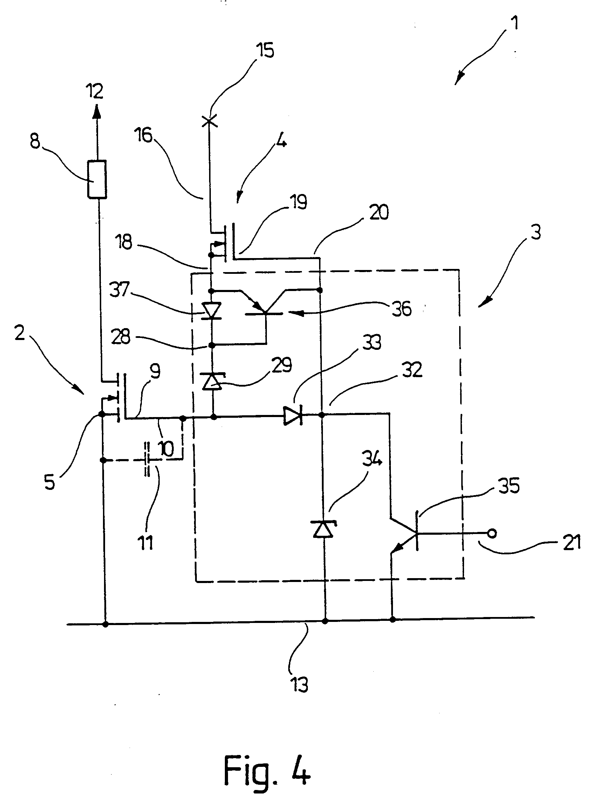

In der Fig. 4 ist die Schaltungsanordnung 1 mit einer abgewandelten Steuerschaltung 3 gemäß einem weiteren Ausführungsbeispiel dargestellt. Die Steuerschaltung 3 unterscheidet sich von der vorstehend beschriebenen Steuerschaltung 3 dadurch, daß zur Verbindung des Verbindungszweiges 28 mit dem Schaltungsknoten 32 anstelle des Widerstandes 31 die Emitter-Kollektor-Strecke eines pnp-Transistors 36 geschaltet ist. Dieser pnp-Transistor 36 ist im Sinne einer Mitkopplung von dem in dem Verbindungszweig 28 fließenden Strom gesteuert. Dazu ist seine Basis-Emitter-Diode, der eine Diode 37 parallel geschaltet ist, in Reihe zu der Z-Diode 29 in dem Verbindungszweig 28 geschaltet. Die Kathode der Diode 37 und die Basis des pnp-Transistors 36 sind mit der Kathode der Z-Diode 29 zusammengeschaltet. Damit dient ein Teil des durch den Verbindungszweig 28 fließenden Stromes als Basisstrom für den pnp-Transistor 36. Je größer der in dem Verbindungszweig 28 fließende Strom ist, desto mehr Strom läßt auch der pnp-Transistor 36 durch; jedoch wird umgekehrt auch der maximal von der Emitter-Kollektor-Strecke durchgelassene Strom von dem Strom in dem Verbindungszweig 28 begrenzt. Die Diode 37 wirkt als Parallelshunt zu der Basis-Emitter-Strecke des Transistors 36.

Die Funktionsweise der abgewandelten Steuerschaltung 3 nach Fig. 4 ist wie folgt:
Ist der Transistor 35 zunächst aufgrund der an den Ansteuereingang 21 angelegten Steuerspannung U₂₁ in dem leitenden Zustand, ist die Gate-Elektrode 9 des Ausgangstransistors 2 über die Diode 33 auf das Bezugspotential 13 geklemmt. Der Ausgangstransistor 2 ist somit gesperrt.

Da in dem Verbindungszweig 28 kein nennenswerter Strom fließt, ist auch der pnp-Transistor 36 im wesentlichen gesperrt. Er ist also sehr hochohmig, so daß auch der geringste durch den Eingangstransistor 4 fließende Reststrom einen Spannungsabfall über der Emitter-Kollektor-Strecke des pnp-Transistors 36 erzeugt, die zwischen der Source-Elektrode 17 und der Gate-Elektrode 19 des Eingangstransistors 4 ansteht. Diese Spannung wirkt als negative Gatevorspannung für den Eingangstransistor 4. Der selbstleitende Eingangstransistor ist sicher gesperrt.

Wird nun, um dem Ausgangstransistor 2 einzuschalten, die an den Ansteuereingang 21 angelegte Steuerspannung U₂₁ auf Null geschaltet, sperrt der Transistor 35 augenblicklich und wird hochohmig. Damit kann kein Kollektorstrom mehr durch den Transistor 36 fließen. Der Reststrom des Eingangstransistors 4 fließt vollständig über die Basis-Emitter-Strecke des pnp-Transistors 36, der dadurch aufgesteuert wird. Gleichzeitig wird die Eingangskapazität des Eingangstransistors 4 über den pnp-Transistor 36 entladen, wodurch der Eingangstransistor 4 zunehmend leitend wird. Dadurch wird der Bais-Strom des pnp-Transistors 36 größer bis dieser in die Sättigung gesteuert ist. Die Eingangskapazität des Eingangstransistors 4 wird noch schneller entladen, was schließlich zum vollen Aufsteuern des Eingangstransistors 4 führt.

Das dabei stattfindende Aufladen der Eingangskapazität 11 des Ausgangstransistors 2 erfolgt in der bereits vorstehend beschriebenen Weise. Der Ladestrom für die Eingangskapazität 11 fließt durch die Basis-Emitter-Diode des pnp-Transistors 36 sowie die parallel geschaltete Diode 37 und hält derart den pnp-Transistor 36 für nicht zu große Kollektorströme in der Sättigung.

Sobald die Gatespannung U₉ an dem Ausgangstransistor 2 einen Betrag erreicht hat, bei dem die um die Z-Spannung der Z-Diode 29 nach oben versetzte Sourcespannung des Eingangstransistors 4 das Potential an dem Schaltungsknoten 32, das durch die Z-Diode 34 festgeklemmt ist, überschreitet, beginnt ein stärkerer Strom durch die Emitter-Kollektor-Strecke des pnp-Transistors 36 über die Z-Diode 34 nach dem Bezugspotential abzufließen. Überschreitet dieser Strom einen gewissen Höchstbetrag, der durch den Basis-Strom des pnp-Transistors 36 und seine Stromverstärkung vorgegeben ist, kommt der pnp-Transistor 36 aus der Sättigung heraus. Es beginnt nun, eine Spannung über der Emitter-Kollektor-Strecke des pnp-Transistors 36 abzufallen. Der Eingangstransistor 4 erhält somit eine zunehmend negative Gatevorspannung und sperrt vollständig. Entsprechend wird der Strom in dem Verbindungszweig 28 verringert. Dadurch wird auch der Basisstrom des pnp-Transistors 36 geringer, wodurch dieser hochohmig wird. Der Ausgangstransistor 2 ist nun voll durchgesteuert und die Schaltungsanordnung 1 ist im Ein-Zustand. Bei dem Einschaltvorgang wird der Einganstransistor nur ganz kurzzeitig aufgesteuert und läßt nur einen kurzen Stromimpuls durch. Dadurch entsteht fast keine Verlustleistung an dem Eingangstransistor 4 und in der Steuerschaltung 3.

Das Verhalten der Schaltung beim Abschalten ist identisch mit dem Abschaltvorgang, der bei der Schaltung nach Fig. 3 abläuft.

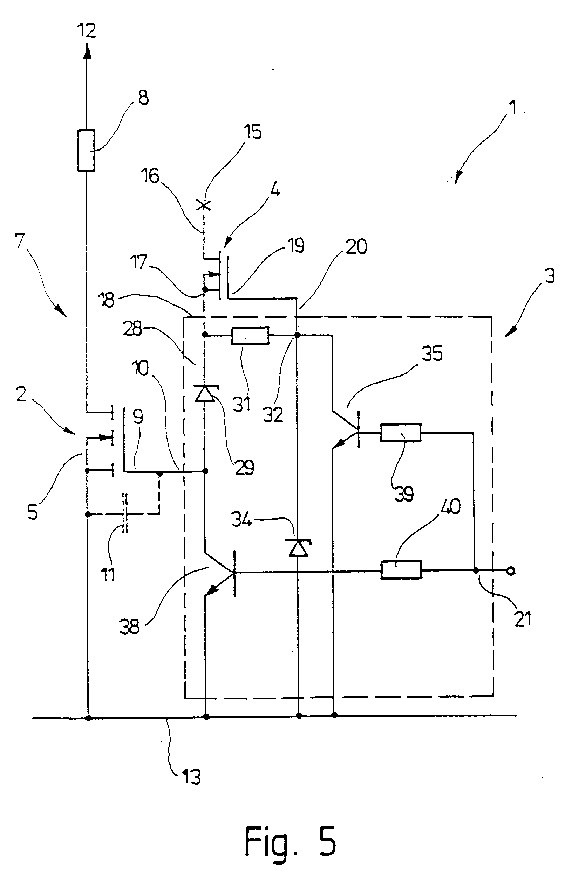

In der Fig. 5 ist ein weiteres Ausführungsbeispiel der Ansteuerschaltung 3 dargestellt. Sie unterscheidet sich von den vorstehend beschriebenden Ansteuerschaltungen 3 dadurch, daß die Gate-Elektrode 9 des Ausgangstransistors 2 nicht über eine Diode mit dem Schaltungsknoten 32 verbunden ist, sondern daß die Gate-Elektrode 9 des Ausgangstransistors 2 über einen eigenen npn-Transistor 38 mit dem Bezugspotential 13 verbunden ist. Die Basen der Transistoren 35 und 38 sind über Widerstände 39, 40 zusammengeschaltet und als Steuereingang herausgeführt. In den übrigen Punkten entspricht die Schaltung nach Fig. 5 der Schaltung nach Fig. 3.

Die Funktionsweise der Schaltung nach Fig. 5 ist wie folgt:
Zum Einschalten des Ausgangstransistors 2 wird eine bisher an den Ansteuereingang 21 angelegte Steuerspannung U₂₁ abgeschaltet, so daß die Transistoren 35 und 38 sperren. Aufgrund der Wirkung der Eingangskapazität 11 des Ausgangstransistors 2 behält die Gate-Elektrode 9 zunächst das Bezugspotential 13 bei. Über den stromfreien Widerstand 31 ist der Schaltungsknoten 32 mit der Source-Elektrode 17 des Eingangstransistors 4 verbunden, so daß der Schaltungsknoten 32 dessen Potential annimmt. Damit ist der Eingangstransistor 4 voll aufgesteuert, wodurch dieser in der vorstehend beschriebenen Weise mit einem kräftigen Stromimpuls über die Z-Diode 29 die Eingangskapazität 11 des Ausgangstransistors 2 auflädt. Überschreitet die Spannung an der Source-Elektrode 17 des Eingangstransistors 4 die Z-Spannung der Z-Diode 34, beginnt ein Strom durch den Widerstand 31 und die Z-Diode 34 zu fließen. Der sich über den Widerstand 31 aufbauende Spannungsabfall regelt den Eingangstransistor 4 entsprechend zu. Inzwischen ist jedoch die Eingangskapazität 11 des Ausgangstransistors 2 soweit geladen, daß dieser voll durchgesteuert ist.

In dem nun erreichten statischen Zustand nimmt die Steuerschaltung 3 praktisch keinen Strom mehr auf und setzt dementsprechend auch keine Verlustwärme frei, d.h. es fließt nur noch der Ruhestrom entsprechend der Größe des Widerstandes 31.

Zum Abschalten des Ausgangstransistors 2 zu dem in Fig. 2 mit 24 bezeichneten Zeitpunkt wird die Steuerspannung mit einer steilen Flanke an den Ansteuereingang 21 angelegt. die Transistoren 35, 38 werden sofort leitend, wobei der Transistor 38 mit seiner Kollektor-Emitter-Strecke die Gate-Elektrode 9 mit der Source-Elektrode 5 des Ausgangstransistors 2 verbindet. Dieser sperrt praktisch sofort. Der Transistor 35 legt das Potential des Schaltungsknotens 32 auf das Bezugspotential 13, wobei der Spannungsabfall über dem Widerstand 31 erhalten und demzufolge der Eingangstransistor 4 gesperrt bleibt.

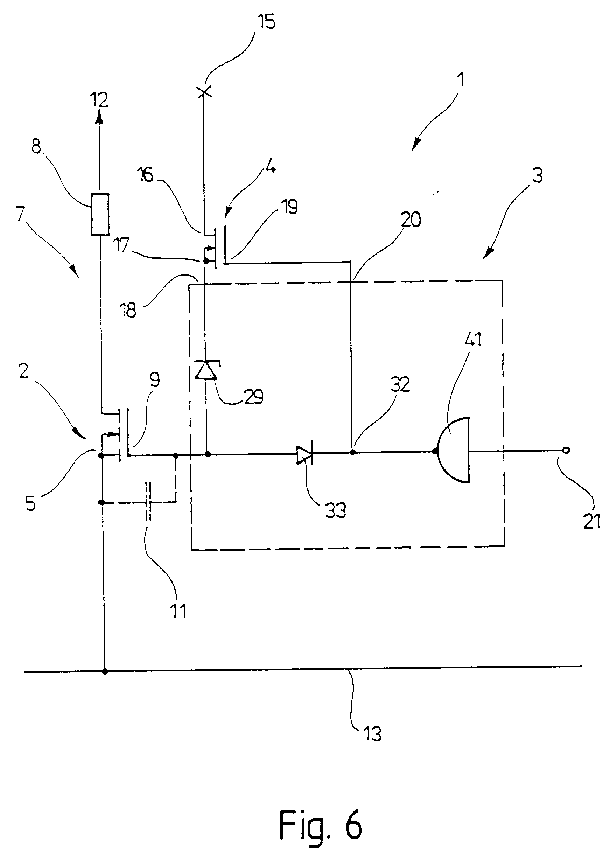

Eine Steuerschaltung 3, die mit extrem wenig Bauelementen auskommt, ist in Fig. 6 dargestellt. Gegenüber der in Fig. 3 dargestellten Ausführungsform der Steuerschaltung unterscheidet sich die in Fig. 6 dargestellte dadurch, daß unter Wegfall des Widerstandes 31 die Z-Diode 34 und der Transistor 35 durch ein Gatter 41, bspw. ein CMOS-Gatter, ersetzt sind. Der Ausgang des Gatters 41 ist direkt mit dem Schaltungsknoten 32 verbunden und der Eingang des Gatters 41 ist als Ansteuereingang 21 aus der Steuerschaltung 3 herausgeführt. Der Ausgang des Gatters kennt zwei Zustände, die dem Ein- bzw. dem Aus-Zustand der Schaltungsanordnung 1 und damit des Ausgangstransistors 2 entsprechen. Bezogen auf das Bezugspotential 13 weist der Ausgang des Gatters 41 und damit des Schaltungsknotens 32 entweder null Volt oder einen bei einer positiven Spannung liegenden Spannungsbetrag auf. Dazu benötigt das Gatter 41 allerdings eine eigene, galvanisch mit der Schaltungsanordnung 1 verbundene Stromversorgung. Die Z-Diode 29 hat eine Z-Spannung von zumindest etwa der Schwellenspannung des Eingangstransistors 4.

Die Funktionsweise der Schaltung nach Fig. 6 ist wie folgt:
Die Schaltungsanordnung 1 nach Fig. 6 nimmt ihren Aus-Zutand ein, wenn der Ausgang des Gatters 41 aufgrund der entsprechenden Steuerspannung U₂₁ an dem Ansteuereingang 21 eine Spannung von ungefähr null Volt einnimmt und damit den Schaltungsknoten 32 auf ein Potential klemmt, das dem Source-Potential des Ausgangstransistors 2 entspricht. Damit liegt die Gate-Elektrode 9 des Ausgangstransistors 2 über die Diode 33 auf dem Potential seiner eigenen Source-Elektrode 5, so daß der Ausgangstransistor 2 sicher gesperrt ist. Die an dem Schaltungsknoten 32 anliegende Gate-Elektrode 19 des Eingangstransistors 4 liegt somit ebenfalls auf ungefähr null Volt. Schon ein ganz geringfügiger auf der Drain-Source-Strecke des Eingangstransistors 4 fliessender Reststrom baut über der in Sperrichtung gepolten Z-Diode 29 einen Spannungsabfall auf, der unterhalb oder bei ihrer Z-Spannung liegt. Dieser Spannungsabfall wirkt aber zugleich zwischen der Source-Elektrode 17 und der Gate-Elektrode 19 des Eingangstransistors 4 als negative Gatevorspannung, so daß dieser sich selbst sperrt.

Schaltet nun das Gatter 41 aufgrund eines entsprechenden Eingangssignals an dem Ansteuereingang 21 um, so daß an seinem Ausgang eine Spannung von bspw. 15 Volt mit dem Innenwiderstand des CMOS-Gatters ansteht, werden der Schaltungsknoten 32 und somit auch die Gate-Elektrode 19 des Eingangstransistors 4 auf diese Spannung gelegt. Die Source-Elektrode 17 des Eingangstransistors 4 wird über die Z-Diode 29 und die Eingangskapazität 11 des Ausgangstransistors 2 ebenfalls auf einem Potential entsprechendd er Nennspannung der Z-Diode 29 gehalten. Somit ist die Source-Elektrode 17 negativ gegenüber der Gate-Elektrode 19 des Eingangstransistors 4, wodurch dieser leitend wird. Er versorgt nun über die Z-Diode 29 die Gate-Elektrode 9 des Ausgangstransistors mit Strom und lädt die Eingangskapazität 11 auf. Damit wird der Ausgangstransistor 2 eingeschaltet, wobei sich mit zunehmender Gate-Spannung an der Gate-Elektrode 9 auch die Spannung an der Source-Elektrode 17 des Eingangstransistors 4 soweit erhöht, bis diese die Ausgangsspannung des Gatters 41 um den Betrag der negativen Gatevorspannung überschreitet, die zum Sperren des Einganstransistors 4 erforderlich ist. Der Einganstransistor 4 sperrt sich somit selbst wieder ab. Auch bei diesem Ausführungsbeispiel ist der Eingangstransistor 4 nur für einen kurzen Stromimpuls geöffnet und ansonsten gesperrt, so daß kaum Verlustleistung entsteht.

Umgekehrt erfolgt das Abschalten der in Fig. 6 dargestellten Schaltungsanordnung 1 und des Ausgangstransistors 2 einfach, indem das Gatter 41 durch einen entsprechenden Impuls an dem Ansteuereingang 21 so geschaltet wird, daß sein Ausgang das Bezugspotential 13 (Masse) annimmt. Der Gatterausgang entlädt über die Diode 33 die Eingangskapazität 11 des Ausgangstransistors 2 und sperrt diesen damit sicher. Der Eingangstransistor 4 bleibt gesperrt.

Aufgrund der bei allen Ausführungsbeispielen äußerst geringen anfallenden Verlustleistung kommen alle praktischen Schaltungsaufbauten ohne oder mit ganz geringen Kühlflächen aus, so daß sich die Schaltungsanordnung 1 in jedem Falle äußerst platzsparend aufbauen läßt.

## Patentansprüche

1. Schaltungsanordnung (1) mit zwei ähnlich einer Darlington-Schaltung miteinander verbundenen Transistoren (2,4), von denen einer einen im Schalterbetrieb arbeitetenden Ausgangstransistor (2) bildet, der ein selbstsperrender Mosfet oder ein Transistor oder eine Zusammenschaltung von Transistoren mit ähnlichen Eingangsparametern ist, und der andere einen Eingangstransistor (4) bildet, und mit einer Steuerschaltung (3) für die Transistoren (2,4), die einen Ansteuereingang (21) aufweist und die den Eingangstransistor (4) lediglich für den Übergang des Ausgangstransistors (2) von dem Aus-Zustand in dessen Ein-Zustand leitend steuert und ansonsten gesperrt hält.

2. Schaltungsanordnung nach Anspruch 1, dadurch gekennzeichnet, daß der Eingangstransistor (4) ein selbstleitender Mosfet ist.

3. Schaltungsanordnung nach Anspruch 1, dadurch gekennzeichnet, daß der Eingangstransistor (4) und der Ausgangstransistor (2) Feldeffekttransistoren vom gleichen Leitfähigkeitstyp sind.

4. Schaltungsanordnung nach Anspruch 1 und 2, dadurch gekennzeichnet, daß der Eingangstransistor (4) und der Ausgangstransistor (2) n-Kanal-Transistoren sind.

5. Schaltungsanordnung nach Anspruch 1 und 2, dadurch gekennzeichnet, daß die Steuerschaltung (3) an eine Gate-Elektrode (9) des Ausgangstransistors (2), an eine Source-Elektrode (17) des Eingangstransistors (4) und an eine Gate-Elektrode (19) des Eingangstransistors (4) angeschlossen ist.

6. Schaltungsanordnung nach Anspruch 1, dadurch gekennzeichnet, daß die Steuerschaltung (3) mit der Source-Elektrode (5) des Ausgangstransistors (2) verbunden ist.

7. Schaltungsanordnung nach Anspruch 1 und 2, dadurch gekennzeichnet, daß die Steuerschaltung (3) einen Verbindungszweig (28) enthält, über den die Source-Elektrode (17) des Eingangstransistors (4) mit der Gate-Elektrode (9) des Ausgangstransistors (2) verbunden ist.

8. Schaltungsanordnung nach Anspruch 7, dadurch gekennzeichnet, daß der Verbindungszweig (28) ein spannungsbegrenzendes Bauelement, vorzugsweise eine Z-Diode (29) enthält, deren Anode mit der Gate-Elektrode (9) des Ausgangstransistors (2) verbunden ist und deren Z-Spannung größer ist als der Betrag der Schwellenspannung des Einganstransistors (4).

9. Schaltungsanordnung nach Anspruch 1 und 2, dadurch gekennzeichnet, daß die Steuerschaltung (3) einen Verbindungszweig enthält, über den die Source-Elektrode (17) und die Gate-Elektrode (19) des Eingangstransistors (4) miteinander verbunden sind.

10. Schaltungsanordnung nach Anspruch 9, dadurch gekennzeichnet, daß der Verbindungszweig ein strombegrenzendes Bauelement (31, 36) enthält.

11. Schaltungsanordnung nach Anspruch 10, dadurch gekennzeichnet, daß das strombegrenzende Bauelement ein Ohm'scher Widerstand (31) ist.

12. Schaltungsanordnung nach Anspruch 1, dadurch gekennzeichnet, daß die Steuerschaltung wenigstens einen Schaltungsknoten (32) aufweist, der im Aus-Zustand des Ausgangstransistors (2) ein Bezugspotential (13) der Source-Elektrode (5) des Ausgangstransistors (2) und im Ein-Zustand ein demgegenüber positives Potential aufweist.

13. Schaltungsanordnung nach Anspruch 12 und 2, dadurch gekennzeichnet, daß der Schaltungsknoten (32) mit der Gate-Elektrode (19) des Eingangstransistors (4) verbunden ist.

14. Schaltungsanordnung nach Anspruch 12, dadurch gekennzeichnet, daß der Schaltungsknoten (32) über ein spannungsbegrenzendes Bauelement, vorzugsweise eine Z-Diode (34), mit der Source-Elektrode (5) des Ausgangstransistors (2) verbunden ist, wobei die Z-Spannung gleich der vorzeichenbehafteten Summe aus der gewünschten Gatespannung an dem Ausgangstransistor (2), der Z-Spannung der anderen Z-Diode (29) und der Schwellenspannung des Eingangstransistors (4) ist.

15. Schaltungsanordnung nach Anspruch 1, dadurch gekennzeichnet, daß die Gate-Elektrode (9) des Ausgangstransistors (2) im Aus-Zustand über einen niederohmigen Strompfad mit der Source-Elektrode (5) des Ausgangstransistors (2) verbunden ist.

16. Schaltungsanordnung nach Anspruch 15, dadurch gekennzeichnet, daß die Gate-Elektrode (9) des Ausgangstransistors (2) mit der Anode einer Diode (33) verbunden ist, deren Kathode an dem Schaltungsknoten (32) liegt.

17. Schaltungsanordnung nach Anspruch 14, dadurch gekennzeichnet, daß dem spannungsbegrenzenden Bauelement (34) die gesteuerte Strecke eines elektronischen Schalters parallel geschaltet ist, die vorzugsweise die Emitter-Kollektor-Strecke eines Bipolartransistors, die Drain-Source-Strecke eines Unipolartransistors, die Emitter-Kollektor-Strecke eines Phototransistors oder die Anoden-Kathoden-Strecke einer Photodiode ist.

18. Schaltungsanordnung nach Anspruch 17, dadurch gekennzeichnet, daß die Basis des npn-Transistors (35) der Ansteuereingang (21) der Steuerschaltung (3) ist.

19. Schaltungsanordnung nach Anspruch 10, dadurch gekennzeichnet, daß das strombegrenzende Bauelement ein steuerbarer Widerstand ist, der von dem in dem Verbindungszweig (28) fließenden Strom gesteuert ist.

20. Steuerschaltung nach Anspruch 10, dadurch gekennzeichnet, daß das strombegrenzende Bauelement (36) ein bipolarer pnp-Transistor (36) ist, dessen Emitter mit dem Source und dessen Kollektor mit der Gate-Elektrode (9) des Eingangstransistors (4) verbunden ist.

21. Schaltungsanordnung nach Anspruch 10, dadurch gekennzeichnet, daß die Basis-Emitter-Diode des pnp-Transistors (36) in dem Verbindungszweig (28) liegt.

22. Schaltungsanordnung nach Anspruch 21, dadurch gekennzeichnet, daß der Emitter des pnp-Transistors (36) mit der Source-Elektrode (17) des Eingangstransistors (4) und seine Basis mit der Z-Diode (29) verbunden ist.

23. Schaltungsanordnung nach Anspruch 22, dadurch gekennzeichnet, daß der Basis-Emitter-Diode des pnp-Transistors (36) eine in gleicher Richtung gepolte Diode (37) parallelgeschaltet ist.

24. Schaltungsanordnung nach Anspruch 12, dadurch gekennzeichnet, daß der Schaltungsknoten (32) mit dem Ausgang eines Gatters (41) verbunden ist.

25. Schaltungsanordnung nach Anspruch 15, dadurch gekennzeichnet, daß die Gate-Elektrode (9) des Ausgangstransistors (2) über die Emitter-Kollektor-Strecke eines Schalttransistors (38) mit der Source-Elektrode (5) des Ausgangstransistors (2) verbunden ist.

26. Schaltungsanordnung nach Anspruch 25, dadurch gekenn zeichnet, daß die Basis des Schalttransistors (38) über einen Widerstand (40) mit dem Ansteuereingang (21) der Steuerschaltung (3) verbunden ist.

27. Steuerschaltung nach Anspruch 25, dadurch gekennzeichnet, daß die Basis des npn-Transistors (35) über einen Widerstand (39) mit dem Steuereingang (18) der Steuerschaltung (3) verbunden ist.
